# FASCICULE DE BREVET EUROPEEN

(11) **EP 2 368 413 B1**
(45) Date de publication et mention de la délivrance du brevet: **19.12.2018**
(21) Numéro de dépôt: 09803794.8
(22) Date de dépôt: 21.12.2009
(51) Int. Cl.: H05K 7/14, H05K 7/20

(54) **PACK ELECTRIQUE A MODULES DE COMMANDE ET DE PUISSANCE SEPARÉS**
ELEKTRISCHES PACK MIT SEPARATEN STEUER- UND STROMMODULEN
ELECTRICAL PACK WITH SEPARATE CONTROL AND POWER MODULES

(30) Priorité: 24.12.2008 FR 0807454
(43) Date de publication de la demande: 28.09.2011
(73) Titulaire: Safran Electronics & Defense, 92100 Boulogne-Billancourt (FR)
(72) Inventeur: MERLET, Etienne, 92100 Boulogne-Billancourt (FR)
(74) Mandataire: Lavialle, Bruno François Stéphane
(86) Numéro de dépôt international: PCT/FR2009/001466
(87) Numéro de publication internationale: WO 2010/072918

(56) Documents cités:
- FR-A1- 2 782 597
- US-A- 5 619 111
- US-A1- 2006 238 975
- US-A1- 2008 007 919

## Description

La présente invention concerne un pack électrique, plus particulièrement bien que non exclusivement un pack de modules de disjoncteur.

### ARRIERE PLAN DE L'INVENTION

Compte tenu de l'usage croissant des commandes électriques dans les véhicules, qu'il s'agisse de véhicules terrestres ou aériens, il est maintenant courant d'équiper ces véhicules de boîtiers électriques regroupant des éléments électromagnétiques et des packs électriques contenant des composants de puissance. Pour faciliter la maintenance du boîtier électrique, les composants sont généralement regroupés selon des modules de puissance comprenant chacun des composants de puissance et des composants de commande portés par des barrettes fixées sur une plaque support. Les éléments électromagnétiques ainsi que les composants de puissance sont reliés à des bus d'alimentation de puissance portés par la plaque support et à des bus de liaison avec les composants de commande.

Il est ainsi possible d'avoir des modules identiques facilitant la réalisation du boîtier électrique. Toutefois, les composants de commande sont soumis à un échauffement résultant de la proximité des éléments électromagnétiques et des composants de puissance de sorte que la fiabilité du module se trouve affectée, notamment en raison de l'élévation plus particulière de la température à l'intérieur d'un boîtier électrique lorsque le boîtier électrique est monté sur un avion prévu pour voler à des altitudes élevées où l'air est raréfié, ou encore dans le cas d'une défaillance du dispositif de ventilation habituellement associé au boîtier électrique.

Le document US 2006/0238975 décrit un dispositif comprenant trois unités de puissance coiffées par une unité de contrôle.

Les documents us 2008 007919 et US 5 619 111 décrivent d'autres architectures de l'art antérieur.

### OBJET DE L'INVENTION

Un but de l'invention est de proposer un pack électrique ayant une fiabilité améliorée.

### RESUME DE L'INVENTION

En vue de la réalisation de ce but, on propose selon l'invention un pack électrique comportant des composants de puissance et des composants de commande répartis selon des modules, dans lequel les composants de puissance sont regroupés selon au moins un module de puissance tandis que les composants de commande sont regroupés selon au moins un module de commande séparé dudit au moins un module de puissance, chaque module de commande comportant une plaque support en métal thermiquement bon conducteur à laquelle est associée une plaque isolante porte composants portant des composants de commande et des circuits de liaison électrique, la plaque porte composants étant espacée de la plaque support, le module de commande étant protégé par la plaque support contre un échauffement provenant d'un module de puissance adjacent.

On comprend par « séparé » le fait que les modules de puissance ne se trouvent pas au contact direct du module de commande.

Ainsi, l'échauffement des composants de commande par convection ou par radiation résultant de l'échauffement des composants de puissance, est minimisé.

Selon une version avantageuse de l'invention, chaque module de puissance comporte une plaque support en métal thermiquement bon conducteur à laquelle est associée une plaque isolante porte composants portant des composants de puissance et des circuits de liaison électrique des composants de puissance, la plaque porte composants étant espacée de la plaque support. Ainsi, un flux d'air s'établit entre la plaque porte composants et la plaque support de sorte que la plaque support est thermiquement associée à la plaque porte composants et sert donc de radiateur de refroidissement pour les composants de puissance.

Selon un mode de réalisation préféré, les modules de puissance comportent des plaques intermédiaires en forme de cadre en métal thermiquement bon conducteur assurant une liaison mécanique et thermique entre la carte porte composants et une plaque support adjacente. Les plaques intermédiaires favorisent ainsi l'établissement d'un flux d'air le long des plaques porte composants et transmettent par conduction aux plaques support la chaleur dégagée par radiation par les composants de puissance. En outre, les plaques intermédiaires forment des obstacles empêchant l'introduction d'un outil entre la plaque porte composants et la plaque support tant que le module n'est pas démonté.

Selon un mode de réalisation préféré, la plaque intermédiaire d'un module de puissance forme un obstacle empêchant l'accès aux pattes de fixation du module de puissance précédent, assurant ainsi un détrompage vis-à-vis du boîtier électrique recevant les packs électriques pour que le bon nombre de modules de puissance soit obligatoirement mis en place.

Selon l'invention, chaque module de commande comporte une plaque support en métal thermiquement bon conducteur à laquelle est associée une plaque isolante portant des composants de commande et des circuits de liaison électrique de commande, la plaque porte composants étant espacée de la plaque support. Ainsi, le module de commande est protégé par la plaque support contre un échauffement provenant d'un module de puissance adjacent. La plaque support joue en outre un rôle d'écran électromagnétique.

De préférence, chaque module de commande comporte un capot ajouré en métal thermiquement bon conducteur ayant un bord entourant la plaque porte composants de commande. Le capot assure tout à la fois l'établissement d'un flux d'air de refroidissement par convection et la protection thermique et électromagnétique des composants de commande.

Le pack électrique selon un mode de réalisation de l'invention comprend plusieurs modules de puissance, notamment identiques entre eux, et un module de commande.

Le pack électrique selon un mode de réalisation de l'invention comprend un ensemble de modules de puissance et de commande qui sont disposés en un empilement dont le dernier module, à l'une de ses extrémités, est un ou le module de commande (selon qu'il y a un unique module de commande ou plusieurs modules de commande dans l'empilement).

### BREVE DESCRIPTION DES DESSINS

D'autres caractéristiques et avantages de l'invention apparaîtront à la lecture de la description qui suit d'un mode de réalisation préféré non limitatif du boîtier électrique selon l'invention, en référence aux figures ci-jointes parmi lesquelles :
- la figure 1 est une vue en perspective d'un groupe de modules comprenant un module de commande et deux modules de puissance,
- la figure 2 est une vue en perspective schématique éclatée du module de commande,
- la figure 3 est une vue en coupe selon la ligne III-III de la figure 2 de la plaque porte composants de commande et du capot ajouré associé,
- la figure 4 est une vue en perspective schématique éclatée d'un module de puissance.

### DESCRIPTION DETAILLEE DE L'INVENTION

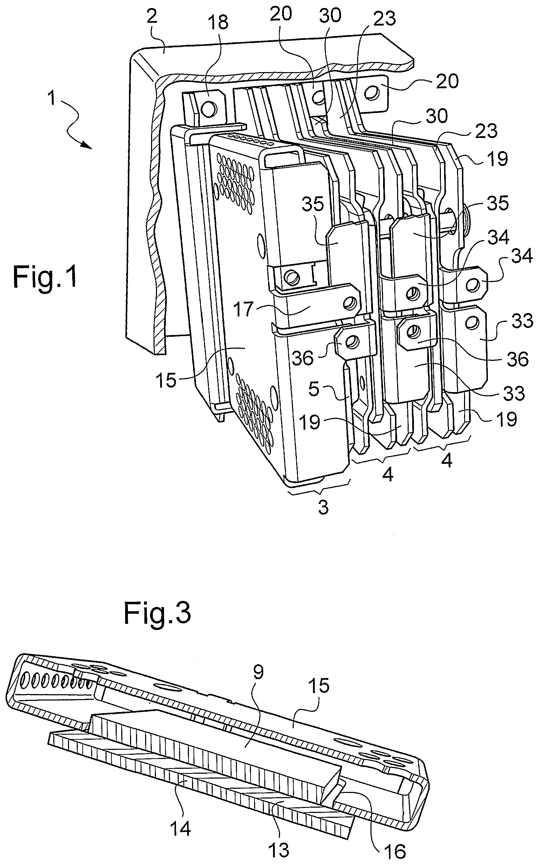

En référence à la figure 1, le boîtier électrique généralement désigné en 1 comprend une enveloppe extérieure 2 équipée de rails supports non représentés sur lesquels sont fixés des groupes de modules appelés packs électriques. La figure 1 illustre un pack électrique comprenant un module de commande 3 et deux modules de puissance 4.

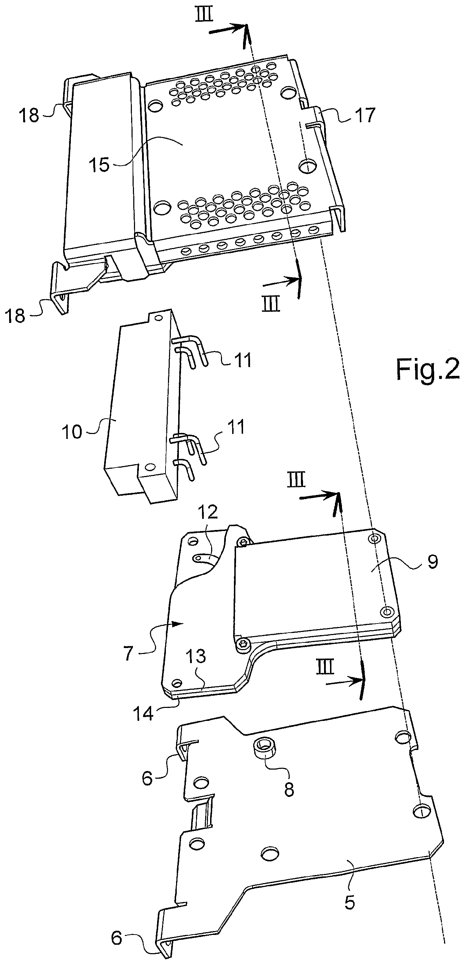

Comme illustré par les figures 2 et 3, le module de commande comporte une plaque support 5 en métal thermiquement bon conducteur, par exemple une plaque en aluminium comportant sur son bord arrière des pattes repliées 6 servant à fixer la plaque support sur un rail support. Une plaque porte composants de commande 7 est fixée à la plaque support 5 par l'intermédiaire d'entretoises d'écartement 8 dont une seule a été représentée sur la figure 2. Sur une face opposée à la plaque support 5, la plaque porte composants 7 comporte un composant de commande 9 (pouvant être lui-même constitué d'une pluralité de composants discrets) équipé d'un connecteur 10 relié par des conducteurs 11 à un circuit de liaison 12 pris en sandwich entre deux plaquettes isolantes 13 et 14 formant la plaque porte composants 7.

Un capot ajouré 15 en métal thermiquement bon conducteur est monté sur la plaque porte composants 7 et comporte un bord 16 qui entoure le composant de commande 9. Le module est maintenu assemblé par des plots (non représentés) passant dans des trous de la plaque support 5 de la plaque porte composants 7 et du capot 15 comme illustré par un trait mixte sur la figure 2. Le capot 15 est en outre équipé sur sa face avant d'une patte 17 assurant une fixation au module de puissance immédiatement adjacent. Sur son bord arrière, le capot 15 comporte des pattes de fixation 18 aux rails supports du boîtier électrique.

Chaque module de puissance 4 comporte une plaque support 19 identique à la plaque support 5 du module de commande. En particulier la plaque support 19 comporte des pattes de fixation 20 permettant un montage aisé sur des réglettes pré percées du boîtier. La plaque 19 comporte en outre une patte d'assemblage 21 dont l'utilité sera vue plus loin. Des entretoises 22 sont disposées pour maintenir un écartement entre la plaque support 19 et une plaque intermédiaire 23 en métal thermiquement bon conducteur et ayant la forme d'un cadre dont un des côtés 24 est cintré perpendiculairement au plan de la plaque 23 de façon que la partie centrale 25 soit en contact avec la plaque support 19 lorsque la plaque intermédiaire 23 est maintenue appliquée contre les entretoises 22. Une plaque porte composants 26 est montée en appui contre la plaque intermédiaire 23. La plaque porte composants 26 comporte des composants de puissance 27 reliés par des circuits de liaison 28 à des pattes de connexion 29 en saillie le long du bord arrière de la carte porte composants 26.

Le module de puissance comporte également une deuxième plaque intermédiaire 30 ayant une structure strictement identique de la plaque intermédiaire 23, montée symétriquement par rapport à la plaque porte composants 26. Lors de l'assemblage d'un groupe de modules, la plaque intermédiaire 30 vient en contact avec la plaque support du module immédiatement adjacent, la partie centrale en saillie 31 du côté arrière étant engagée sous la patte d'emboîtement 21 de la plaque support correspondante du module immédiatement adjacent. Par ailleurs, afin de permettre un assemblage des modules entre eux sur leur face avant la plaque intermédiaire 23 comporte une patte d'assemblage 33 qui est recouverte lors de l'assemblage par une patte d'assemblage correspondante 36 de la plaque intercalaire 30 du module adjacent, et la plaque intermédiaire 23 comporte une patte d'assemblage 34 qui vient recouvrir la patte d'assemblage correspondante 35 de la plaque intercalaire 30 du module adjacent comme illustré par la figure 1. La patte d'assemblage 17 du module de commande est assemblée avec une patte d'assemblage 36 du module de puissance adjacent.

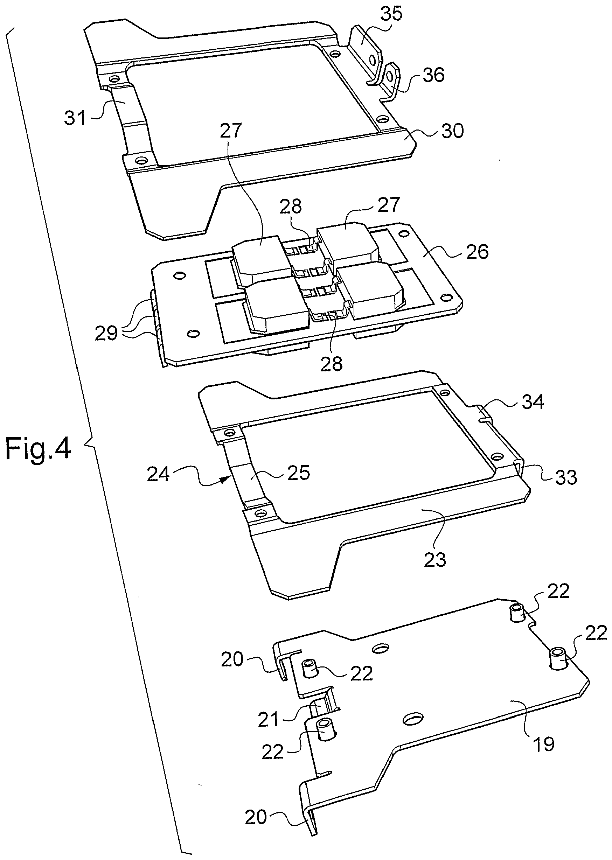

De même il apparaît sur la figure 4 que les pattes de fixation 20 de la plaque support 19 sont tournées vers l'extérieur du module. Comme illustré par la figure 1 sur laquelle la plaque intercalaire 30 du dernier module de puissance a été représentée écorchée, les plaques intercalaires 23 et 30 d'un module masquent les pattes de fixation 20 du module précédent.

Cette conception des plaques intermédiaires 23 et 30 est telle que la mise en place d'un module de puissance supplémentaire en extrémité du pack électrique inhibe l'accès aux pattes de fixation 20 du module de puissance précédemment assemblé. Ceci permet de réaliser un détrompage lors du montage des packs dans le boîtier électrique 1 pour s'assurer que tout pack monté présente le bon nombre de modules de puissance.

En position assemblée la plaque porte composants 26 est prise en sandwich entre les plaques intermédiaires 23 et 30 en forme de cadre qui entourent les composants de puissance sur chacune des faces de la plaque porte composants 26 en étant en contact avec la plaque porte composants 26 d'une part et les plaques supports correspondantes d'autre part. Ainsi les plaques intermédiaires 23 et 30 reçoivent par radiation et par conduction la chaleur émise par les composants de puissance 27 et diffusent cette chaleur par conduction vers les plaques supports et par convection dans le flux d'air qui s'écoule entre les plaques supports, les plaques intermédiaires et les plaques porte composants.

Pour augmenter les transferts thermiques, il est aussi possible d'établir un contact thermique direct entre les composants de puissance 27 et les plaques supports correspondantes.

Le principe du pack électrique permet, par simple assemblage, la configuration à volonté d'autant de modules de puissance que nécessaire pour un même module de commande. La connectique de commande entre le module de commande et les différents modules de puissance est assurée soit par un branchement parallèle des modules entre eux, soit par un branchement série lors des emboîtements successifs des éléments. Il est ainsi possible, avec seulement deux modules différenciés, de constituer toute une gamme de packs électriques totalement modulaires.

Bien que l'invention ait été décrite avec des modules de puissance comprenant une plaque porte composants prise en sandwich entre des plaques intermédiaires, on peut également réaliser les modules de puissance avec des plaques porte composants s'étendant perpendiculairement à la plaque support de façon à réaliser des conduits longitudinaux favorisant un mouvement de convection même dans les cas où le système de ventilation forcée du boîtier électrique est en panne.

## Revendications

1. Pack électrique comportant des composants de puissance (27) et des composants de commande (9) répartis selon des modules, les composants de puissance (27) étant regroupés selon au moins un module de puissance (4) tandis que les composants de commande (9) sont regroupés selon au moins un module de commande (3), le pack étant **caractérisé en ce que** ledit au moins un module de commande est séparé dudit au moins un module de puissance (4), chaque module de commande (3) comportant ainsi une plaque support (5) en métal thermiquement bon conducteur à laquelle est associée une plaque isolante porte composants (7) portant des composants de commande (9) et des circuits de liaison électrique (12), la plaque porte composants (7) étant espacée de la plaque support (5), le module de commande étant protégé par la plaque support contre un échauffement provenant d'un module de puissance adjacent.

2. Pack électrique selon la revendication 1, **caractérisé en ce que** chaque module de puissance (4) comporte une plaque support (19) en métal thermiquement bon conducteur à laquelle est associée une plaque isolante porte composants (26) portant des composants de puissance (27) et des circuits de liaison électrique (28) des composants de puissance, la plaque porte composants (26) étant espacée de la plaque support (19).

3. Pack électrique selon la revendication 2, **caractérisé en ce que** les modules de puissance (4) comportent des plaques intermédiaires (23, 30) en forme de cadre en métal thermiquement bon conducteur assurant une liaison mécanique et thermique entre la carte porte composants (26) et des plaques supports (19) adjacentes.

4. Pack électrique selon la revendication 3, **caractérisé en ce que** la plaque intermédiaire (23, 30) entoure les composants de puissance (27) tout en étant espacée de ceux-ci.

5. Pack électrique selon la revendication 3, **caractérisé en ce que** la plaque intermédiaire (23, 30) comporte une partie en relief (25, 31) en contact direct avec la plaque support (19) adjacente.

6. Pack électrique selon la revendication 5, **caractérisé en ce que** chaque plaque porte composants (26) est prise en sandwich entre deux plaques intermédiaires (23, 30).

7. Pack électrique selon la revendication 1, **caractérisé en ce que** chaque module de commande comporte un capot ajouré (15) en métal thermiquement bon conducteur ayant un bord (16) entourant le composant de commande (9) .

8. Pack électrique selon la revendication 1, **caractérisé en ce qu'**il comporte un assemblage de plusieurs modules de puissance (4) accolés les uns aux autres et associés à un module de commande (3) disposé à une extrémité de l'assemblage.

9. Pack électrique selon la revendication 1 et la revendication 2, **caractérisé en ce que** la plaque support (19) du module de puissance est identique à la plaque support (5) du module de commande.

10. Pack électrique selon la revendication 3, **caractérisé en ce que** la plaque support des modules de puissance comporte des pattes de fixation (20) qui sont disposées pour être masquées par les plaques intercalaires (23, 30) d'un module suivant dans un assemblage de modules.

11. Pack électrique selon l'une des revendications précédentes, **caractérisé en ce qu'**il comprend plusieurs modules de puissance (4) identiques et un module de commande (3).

12. Pack électrique selon l'une des revendications précédentes, **caractérisé en ce qu'**il comprend un ensemble de modules de puissance (4) et de commande (3) qui sont disposés en un empilement dont le dernier module, à l'une de ses extrémités, est un/le module de commande (3).

## Patentansprüche

1. Elektrischer Pack, umfassend Leistungsbauteile (27) und Steuerbauteile (9), die nach Modulen verteilt sind, wobei die Leistungsbauteile (27) in mindestens einem Leistungsmodul (4) zusammengefasst sind, während die Steuerbauteile (9) in mindestens einem Steuermodul (3) zusammengefasst sind, wobei der Pack **dadurch gekennzeichnet ist, dass** das genannte mindestens eine Steuermodul von dem genannten mindestens einen Leistungsmodul (4) getrennt ist, wobei jedes Steuermodul (3) folglich eine Trägerplatte (5) aus einem gut wärmeleitenden Metall umfasst, mit der eine Bauteile tragende Isolierplatte (7) verbunden ist, die Steuerbauteile (9) und Stromkreise (12) für eine elektrische Verbindung trägt, wobei die Bauteile tragende Platte (7) zur Trägerplatte (5) beabstandet ist, wobei das Steuermodul durch die Trägerplatte vor einer Erwärmung geschützt wird, die aus einem angrenzenden Leistungsmodul stammt.

2. Elektrischer Pack nach Anspruch 1, **dadurch gekennzeichnet, dass** jedes Leistungsmodul (4) eine Trägerplatte (19) aus einem gut wärmeleitenden Metall umfasst, mit der eine Bauteile tragende Isolierplatte (26) verbunden ist, die Leistungsbauteile (27) und Stromkreise (28) für eine elektrische Verbindung der Leistungsbauteile trägt, wobei die Bauteile tragende Platte (26) zur Trägerplatte (19) beabstandet ist.

3. Elektrischer Pack nach Anspruch 2, **dadurch gekennzeichnet, dass** die Leistungsmodule (4) Zwischenplatten (23, 30) in Form eines Rahmens aus gut wärmeleitendem Metall umfassen, die eine mechanische und thermische Verbindung zwischen der Bauteile tragenden Platte (26) und den angrenzenden Trägerplatten (19) gewährleisten.

4. Elektrischer Pack nach Anspruch 3, **dadurch gekennzeichnet, dass** die Zwischenplatte (23, 30) die Leistungsbauteile (27) umschließt, während sie zu denselben beabstandet ist.

5. Elektrischer Pack nach Anspruch 3, **dadurch gekennzeichnet, dass** die Zwischenplatte (23, 30) einen erhabenen Teil (25, 31) umfasst, der in direktem Kontakt mit der angrenzenden Trägerplatte (19) ist.

6. Elektrischer Pack nach Anspruch 5, **dadurch gekennzeichnet, dass** jede Bauteile tragende Platte (26) in Sandwichanordnung zwischen zwei Zwischenplatten (23, 30) angeordnet ist.

7. Elektrischer Pack nach Anspruch 1, **dadurch gekennzeichnet, dass** jedes Steuermodul eine durchbrochene Abdeckung (15) aus gut wärmeleitendem Metall umfasst, die einen Rand (16) hat, der das Steuerbauteil (9) umschließt.

8. Elektrischer Pack nach Anspruch 1, **dadurch gekennzeichnet, dass** er eine Anordnung aus mehreren Leistungsmodulen (4) umfasst, die aneinandergefügt und mit einem Steuermodul (3) verbunden sind, das an einem Ende der Anordnung angeordnet ist.

9. Elektrischer Pack nach Anspruch 1 und Anspruch 2, **dadurch gekennzeichnet, dass** die Trägerplatte (19) des Leistungsmoduls identisch zur Trägerplatte (5) des Steuermoduls ist.

10. Elektrischer Pack nach Anspruch 3, **dadurch gekennzeichnet, dass** die Trägerplatte der Leistungsmodule Befestigungslaschen (20) umfasst, die so angeordnet sind, dass sie von den dazwischen eingefügten Platten (23, 30) eines folgenden Moduls in einer Modulanordnung verdeckt werden.

11. Elektrischer Pack nach einem der vorhergehenden Ansprüche, **dadurch gekennzeichnet, dass** er mehrere identische Leistungsmodule (4) und ein Steuermodul (3) umfasst.

12. Elektrischer Pack nach einem der vorhergehenden Ansprüche, **dadurch gekennzeichnet, dass** er eine Einheit aus Leistungsmodulen (4) und Steuermodulen (3) umfasst, die in einem Stapel angeordnet sind, dessen letztes Modul an einem seiner Enden ein/das Steuermodul (3) ist.

## Claims

1. An electrical pack comprising power components (27) and control components (9) distributed in modules, the power components (27) are grouped together in at least one power module (4) while the control components (9) are grouped together in at least one control module (3), the pack being **characterized in that** at least one control module is separate from said at least one power module (4),
each control module (3) thus including a support plate (5) made of a metal that is a good conductor of heat and that is associated with an insulating component carrier plate (7) carrying control components (9) and electrical connection circuits (12), the component carrier plate (7) being spaced apart from the support plate (5), the control module being protected by the support plate against heating coming from an adjacent power module.

2. An electrical pack according to claim 1, **characterized in that** each power module (4) includes a support plate (19) made of a metal that is a good conductor of heat and associated with an insulating component carrier plate (26) carrying power components (27) and electrical connection circuits (28) of the power components, the component carrier plate (26) being spaced apart from the support plate (19).

3. An electrical pack according to claim 2, **characterized in that** the power modules (4) include intermediate plates (23, 30) in the form of frames made of a metal that is a good conductor of heat and providing a mechanical and thermal connection between the component carrier plate (26) and the adjacent support plates (19).

4. An electrical pack according to claim 3, **characterized in that** the intermediate plate (23, 30) surrounds the power components (27) while being spaced apart therefrom.

5. An electrical pack according to claim 3, **characterized in that** the intermediate plate (23, 30) includes a portion in relief (25, 31) in direct contact with the adjacent support plate (19).

6. An electrical pack according to claim 5, **characterized in that** each component carrier plate (26) is sandwiched between two intermediate plates (23, 30).

7. An electrical pack according to claim 1, **characterized in that** each control module includes a perforated cover (15) made of a metal that is a good conductor of heat having an edge (16) surrounding the control component (9) .

8. An electrical pack according to claim 1, **characterized in that** it comprises an assembly of a plurality of power modules (4) adjacent to one another and associated with a control module (3) located at one end of the assembly.

9. An electrical pack according to claim 1 and claim 2, **characterized in that** the support plate (19) of the power module is identical to the support plate (5) of the control module.

10. An electrical pack according to claim 3, **characterized in that** the support plate of a power module includes fastener tabs (20) that are arranged to be masked by the intermediate plates (23, 30) of a following module in an assembly of modules.

11. An electrical pack according to any preceding claim, **characterized in that** it comprises a plurality of identical power modules (4) and a control module (3).

12. An electrical pack according to any preceding claim, **characterized in that** it comprises a set of power (4) and control (3) modules that are disposed in a stack, in which the last module at one of the ends of the stack is the or one of the control modules (3).
